# EUROPÄISCHE PATENTANMELDUNG

(11) **EP 1 209 254 A2**
(43) Veröffentlichungstag der Anmeldung: **29.05.2002**
(21) Anmeldenummer: 01125105.5
(22) Anmeldetag: 23.10.2001
(51) Int. Cl.: C23C 30/00, C23C 16/30

(54) **Schneidwerkzeug zum Zerspanen**

(30) Priorität: 27.11.2000 DE 10058803
(71) Anmelder: Widia GmbH, 45145 Essen (DE)
(72) Erfinder: König, Udo, Dr., 45149 Essen (DE); Tabersky, Ralf, Dipl.-Phys., 46240 Bottrop (DE)
(74) Vertreter: Vomberg, Friedhelm, Dipl.-Phys.

(57) **Zusammenfassung**

Die Erfindung betrifft ein aus einem Substratkörper und mindestens einer Schicht bestehendes Schneidwerkzeug. Eine dieser Schichten besitzt die Zusammensetzung MeSₓN_{y} mit Me = Ti, Zr oder Hf und 0,1 ≤ y ≤ 0,9 und 0,1 ≤ x ≤ 2,2. Soweit die MeSₓNy-Schicht einen Zusammensetzungsgradienten aufweist, können die Werte auch 0 ≤ x ≤ 2,2 und 0 ≤ y ≤ 1 betragen.

## Beschreibung

Die Erfindung betrifft ein Schneidwerkzeug zum Zerspanen, bestehend aus einem Hartmetall-, Cermet-, Keramik- oder Stahlgrundkörper und mindestens einer hierauf abgeschiedenen Schicht, wovon die einzige oder mindestens eine, mindestens 0,5 µm dicke Schicht, Anteile aus einem Metallsulfid- Festschmierstoff der Zusammensetzung MeSₓ mit Me = Ti, Zr oder Hf, vorzugsweise TiSₓ enthält.

Die Erfindung betrifft ferner ein Verfahren zur Herstellung eines solchen Schneidwerkzeuges.

Aus der EP 0 907 764 B1 ist ein Schneidwerkzeug bekannt, das aus einem Substratkörper und mindestens einer hierauf abgeschiedenen Schicht, die im wesentlichen aus Carbiden, Nitriden, Carbonitriden, Oxicarbonitriden, Oxiden und/oder Boriden mindestens eines der Elemente der IVa- bis VIa-Gruppe des Periodensystems oder aus einer Keramik, vorzugsweise Al₂O₃ besteht, wobei die einzige Schicht oder bei mehreren Schichten zumindest die äußere Schicht eine dispersive zweite Phase aus mindestens einem Titansulfid und/oder Titanselenit enthält. Der Anteil dieser zweiten Phase, die insbesondere aus TiSₓ mit x = 1 bis 2, vorzugsweise x = 1,5 bis 2 besteht, soll bis zu 2 Massen-%, vorzugsweise 1 Massen-% betragen. Weiterhin wird in dieser Schrift vorgeschlagen, daß die Verteilung der zweiten Phase in dieser Schicht im wesentlichen homogen ist oder einen gradiellen Verlauf mit höheren Sulfid- oder Selenitanteilen in den oberflächennahen Zonen aufweist, wobei vorzugsweise der Anteil der zweiten Phase in einer Eindringtiefe bis zu 1 bis 2 µm von der Oberfläche aus bis zu 50 % beträgt und in größeren Eindringtiefen stufenweise oder kontinuierlich abnimmt.

Aus der EP 0 534 905 A2 ist bekannt, Werkzeuge für die zerspanende Bearbeitung von Werkstoffen mit einer Oberflächenschicht zu versehen, die aus mindestens einer Verbindung aus mindestens einem Hauptgruppenelement der VI-Gruppe des periodischen Systems einerseits und mindestens einem Nebengruppenelement der V. und VI. Gruppe des Periodensystems andererseits bestehen. Als bevorzugt werden Selenite, Sulfide, und Tellurite der Elemente Molybdän, Niob, Tantal und Wolfram vorgeschlagen, wovon sich in der jüngsten Zeit insbesondere das Molybdänsulfid durchgesetzt hat.

In der DD 202 898 wird vorgeschlagen, auf Schnitt-, Stanz-, Zieh- und Zerspanungswerkzeugen, Lagern oder ähnlichem Molybdändisulfid durch Sputtern aufzutragen, wobei sich die Schichtdicke im nm-Bereich bewegen soll.

Zudem wird in der DE 198 25 572 A1 ein Werkzeug vorgeschlagen, bei dem die einzige oder die äußere Schicht im wesentlichen aus Molybdänsulfid besteht und einen Chlorgehalt von 0,5 bis 6 Atom-% aufweist. Durch diese Maßnahme soll die Haftung und die Oxidationsbeständigkeit der Molybdänschicht verbessert werden.

In der DE 195 11 829 A1 wird ein Schneidwerkzeug mit einem Schaft und einem Schneidenteil beschrieben, das mit einer Gleitschicht geringerer Härte als eine Grundschicht des Schneidteils beschichtet ist. Der Grundkörper des Schneidteiles soll aus HSS, Hartmetall, Cermet oder Keramik und die Grundschicht aus TiN, TiAlN, TiCN, Diamant oder ähnlichem bestehen. Als Gleitschichtmaterial werden Sulfide, Selenite oder Tellurite der Elemente Molybdän, Niob, Tantal oder Wolfram genannt.

Auch bei mit einer Hartstoff- oder Keramik-Beschichtung versehenen Werkzeugen besteht der Nachteil, daß bei hohen Schnittgeschwindigkeiten und/oder großen Spanungsquerschnitten mitunter insbesondere bei schwer zerspanbaren Werkstoffen hohe Temperaturen an der Schneide des Werkzeuges entstehen, die wiederum einen erhöhten Verschleiß, z.T. auch Kantenausbrüche zur Folge haben. Um die beim Zerspanen an der Werkzeugschneide auftretenden Temperaturen zu minimieren, werden daher üblicherweise sogenannte Kühlschmierstoffe verwendet, die jedoch umwelt- und gesundheitsgefährdende Substanzen enthalten und unter Aufwendung hoher Kosten entsorgt werden müssen.

Eine Festschmierstoffschicht, z.B. aus MoS₂, hat demgegenüber zwar den Vorteil, daß beim Zerspanen auf Kühlschmierstoffe verzichtet werden kann, jedoch mangelt es solchen Festschmierstoffschichten an der für eine größere Verschleißfestigkeit erforderlichen Härte sowie an einer ausreichenden Haftfestigkeit.

Die in der EP 0 907 764 B1 beschriebene Schicht mit einer zusätzlichen dispersiven zweiten Phase aus Titansulfid und/oder Titanselenit ist mit dem vorgesehenen 2 %-Gehalt deutlich zu niedrig.

Es ist daher Aufgabe der vorliegenden Erfindung, eine Schichtzusammensetzung anzugeben, die als äußere Schicht, insbesondere auf einer oder mehreren vorhandenen Schichten auf dem Substratkörper eine verbesserte Haftung, eine ausreichende Verschleißfestigkeit und/oder eine gute Oxidationsbeständigkeit aufweist.

Diese Aufgabe wird durch ein Schneidwerkzeug nach Anspruch 1 gelöst. Erfindungsgemäß besitzt die Schicht mit Anteilen aus einem Festschmierstoff eine Zusammensetzung der Form MeSₓN_{y} mit 0,1 ≤ y ≤ 0,9 und 0,1 ≤ x ≤ 2,2.

Überraschenderweise ist festgestellt worden, daß sich TiN mit TiSₓ in weiten Grenzen mischen läßt, wobei Phasengemische aus Titannitrid mit TiS und/oder TiS₂ ebenso erlaubt sind wie die vorstehend benannten Mischphasen.

Weiterbildungen der Erfindung sind in der Unteransprüchen beschrieben.

Vorzugsweise besteht die Schicht mit Anteilen aus einem Festschmierstoff aus einer Zusammensetzung TiSₓN_{y} mit 0,2 ≤ y ≤ 0,8 und 0,2 ≤ x ≤ 1,6, insbesondere wenn zu deren Abscheidung das sogenannte plasmaunterstützte CVD-Verfahren verwendet wird, wie es beispielsweise in der DE 39 41 731 C1 grundlegend beschrieben ist.

Die Dicke der Schicht mit Anteilen aus einem Festschmierstoff liegt bevorzugt zwischen 1 µm und 5 µm. Die erfindungsgemäße Schicht kann als äußere Schicht oder als Zwischenschicht einer mehrlagigen Beschichtung vorgesehen sein.

Bevorzugt ist auf dem Grundkörper eine mehrlagige Schicht abgeschieden worden, wovon mindestens eine Schicht im wesentlichen aus Carbiden, Nitriden, Carbonitriden, Oxicarbonitriden, Oxiden und/oder Boriden mindestens eines der Elemente der IVa- bis VIa-Gruppe des Periodensystems oder aus einer Keramik, vorzugsweise Al₂O₃, besteht. Solche Schichten in ein- oder mehrlagiger Form sind grundsätzlich nach dem Stand der Technik bekannt, allerdings nicht im Zusammenhang mit der nach Anspruch 1 vorgesehenen Schicht.

Nach einer weiteren Ausgestaltung der Erfindung besteht mindestens eine oder mehrere unmittelbar auf dem Grundkörper abgeschiedene Schicht bzw. Schichten aus einem Metall-Carbid, Nitrid, Carbonitrid, Oxicarbonitrid und/oder Oxid, wobei das Metall eines oder mehrere Elemente der IVa- bis VIa-Gruppe des Periodensystems, vorzugsweise Ti, Zr und/oder Hf ist, wobei die Schicht mit Anteilen aus einem Festschmierstoff die äußere Schicht oder eine Zwischenschicht ist, auf der als äußere 0,5 bis 5 um dicke Schicht ein Hartstoff aus einem Carbid, Nitrid, Carbonitrid, Oxicarbonitrid, Oxid und/oder Borid, vorzugsweise TiN oder TiCN, oder eine 0,5 bis 5 µm dicke äußere Schicht aus Al₂O₃ abgeschieden ist. Soweit die MeSₓN_{y}-Schicht eine Zwischenschicht ist, ist diese nach einer ersten Ausführungsform der Erfindung im wesentlichen homogen.

Nach einer zweiten Ausführungsform der Erfindung sind jedoch Schneidwerkzeuge zum Zerspanen angesprochen, die aus einem Hartmetall-, Cermet-, Keramik- oder Stahlgrundkörper bestehen und mehrere hierauf abgeschiedene Schichten aufweisen, wovon mindestens eine aus einem Carbid, Nitrid, Carbonitrid, Oxicarbonitrid, Oxid und/oder Borid mindestens eines der Elemente der IVa- bis VIa-Gruppe des Periodensystems, oder aus einer Keramik, vorzugsweise Al₂O₃ besteht und eine Schicht Anteile aus einem Festschmierstoff der Zusammensetzung MeSₓN_{y} enthält. Die MeSₓN_{y}-Zwischenschicht weist einen Gradientenverlauf mit kontinuierlich oder stufenweise wachsenden oder fallenen Stickstoff- oder Schwefelanteilen auf, die Werte von 0 ≤ x ≤ 2,2 und 0 ≤ y ≤ 1 aufweisen.

Hierbei ist insbesondere an folgende Schichtfolgen gedacht, die auf dem Grundkörper, vorzugsweise aus Hartmetall, abgeschieden sind:
TiN-TiSₓN_{y}-TiSₓ-TiSₓN_{y}-TiN,
TiN-TiSₓN_{y}-TiSₓ-TiSₓN_{y}-Al₂O₃,
TiCN-TiSₓN_{y}-Al₂O₃ oder
TiCN-TiSₓN_{y}-TiN (Schichtfolge jeweils von innen nach außen). Vorzugsweise weist die auf die grundkörpernähere TiN oder TiCN abgeschiedene TiSₓN_{y}-Schicht von innen nach außen einen wachsenden Sₓ-Anteil und einen fallenden Ny-Anteil, insbesondere bis auf Y = 0, auf, während in der auf die TiSₓ-Schicht abgeschiedene TiSₓN_{y}-Schicht der Sₓ-Anteil fällt und der N_{y}-Anteil von innen nach außen wächst.

Durch Variation des Schwefelgehaltes in der TiSₓN_{y}-Schicht lassen sich Härtewerte zwischen 2200 HV05 (TiN) und ca. 1000 HV05 (TiSₓ) einstellen. Wie beschrieben können gleitende Übergänge vom Titannitrid zum Titansulfid der Form TiN-TiSₓN_{y}-TiSₓ realisiert werden, wodurch die Haftung zwischen der inneren TiN-Schicht und der äußeren TiSₓ-Schicht verbessert wird. Insbesondere wenn die TiSₓN_{y}-Schicht einen Gradienten (mit wachsendem Stickstoffgehalt bei fallendem Schwefelgehalt oder umgekehrt) aufweist, kann die Haftung der dargestellten Schichten erheblich verbessert werden. Die erfindungsgemäße Schichtzusammensetzung ist bis ca. 750°C oxidationsbeständig. Besondere Vorteile hat auch die auf einem Substratkörper (von innen nach außen) abgeschiedene Schichtfolge TiCN-TiSₓN_{y}-Al₂O₃. Die TiSₓN_{y}-Zwischenschicht fördert hierbei die Nukleation von α-Al₂O₃ und erlaube eine Abscheidung von dickeren Al₂O₃-Schichten mit guter Haftung.

Unmittelbar auf den Substratkörper aufgetragene TiN- und/oder TiCN-Schichten dienen in nach dem Stand der Technik grundsätzlich bekannter Weise als Sperrschichten, welche eine Diffusion eines etwa vorhandenen Ni-Bindemetalls in die weiteren Schichten und/oder eine Carburierung verhindern.

Die beschriebene TiSₓN_{y}-Schicht wird vorzugsweise durch das im Anspruch 8 beschriebene Verfahren aufgetragen. Hierbei wird erfindungsgemäß mittels einer chemischen Dampfabscheidung (CVD, die ggf. auch plasmaunterstützend sein kann (PCVD)) durch in die Gasphase eingeleitete Schwefelspender, nämlich H₂S, SF₆, SF₄, SO₂ und/oder COS, und Stickstoff (N₂) sowie Ti, Zr und/oder Hf-Halogenide, Wasserstoff sowie ggf. Argon, die TiSₓN_{y}-Schicht abgeschieden. Vorzugsweise kann während der Abscheidung dieser Schicht der Schwefelspender-Gehalt und der N₂-Gehalt entsprechend dem gewünschten Schichtgradientenverlauf verändert werden, so daß ein kontinuierlicher Übergang von einer harten TiN-Schicht und einer weicheren Festschmierstoffschicht TiSₓ geschaffen werden kann. Durch die Anwendung einer derartigen Gradientenschicht wird ein sehr fester Verbund mit dem Schneideinsatz geschaffen. Umgekehrt kann auf diese Weise auch eine äußere, auf die Festschmierstoffschicht folgende TiN- oder Al₂O₃-Schicht angebunden werden, wobei der Schwefelgehalt in der Gasphase mit wachsender Beschichtungsdauer abnimmt und der Stickstoffgehalt entsprechend zunimmt.

Das bevorzugte PCVD-Verfahren wird unter einem Druck von 50 Pa bis 1000 Pa und Temperaturen von 500°C bis maximal 750°C durchgeführt. Bei einem solchen Verfahren, mittels dessen mehrere Hartstoffschichten einschließlich der erfindungsgemäßen Schicht aufgetragen werden, wird die Schichtfolge durch Änderung der Gaszusammensetzung "in einer Hitze" erzeugt.

Weitere Vorteile der Erfindung ergeben sich aus nachfolgenden Ausführungsbeispielen.

Ausgangspunkt waren handelsübliche Wendeschneidplatten der Ausführungsform CNMG120408 aus einer Hartmetallegierung, die sich aus 6 Massen-% Co, 8 Massen-% (Ti,Ta,Nb)C und 86 Massen-%% WC zusammensetzt. Unter den verschiedenartigen nach dem Stand der Technik bekannten CVD- und PVD-Beschichtungsverfahren zur Herstellung von verschleißbeständigen Schichten ist das durch ein Glimmentladungsplasma aktivierte CVD-Verfahren ausgewählt worden, das im einzelnen in der DE 38 41 731 C1 beschrieben ist. Mit diesen Verfahren wurde zunächst bei einer Temperatur von 620°C, einem Druck von 300 Pa und unter Verwendung einer Gasmischung aus 77 Vol-% H₂, 10 Vol-% N₂, 12 Vol-% Ar und 1 vol-% TiCl₄ auf den Hartmetallsubstraten eine 4 µm dicke Schicht aus Titannitrid abgeschieden. Während der Beschichtungszeit von 150 Minuten wurde durch eine gepulste Gleichspannung (Spannung 470 V, Pulsdauer 50 µs, Pulspause 80 µs) ein Glimmentladungsplasma aufrechterhalten. Bei sonst gleichbleibenden Einstellungen wurde sodann eine Gasmischung aus 96 Vol-% H₂, 2 Vol-% H₂S und 2 Vol-% TiCl₄ eingeleitet. Im Anschluß an diesen 90 Minuten dauernden Schritt wurde die Energiezufuhr abgeschaltet. Die Proben wurden abschließend in einer Atmosphäre aus Wasserstoff und Argon abgekühlt.

Die erfindungsgemäße TiSₓN_{y} mit Konzentrationsänderungen der Elemente Schwefel und Stickstoff wird im Prinzip in gleicher Weise hergestellt, jedoch wird sukzessive die Stickstoffgaszufuhr gedrosselt und gleichzeitig der H₂S-Gasstrom verstärkt.

In einem weiteren Versuch wurde zunächst wie im ersten Versuch verfahren. Im Anschluß an die Abscheidung der TiN-Schicht wurde der N₂-Fluß innerhalb von 30 Min. in 5 Schritten von 10 Vol-% N₂ auf 0 gedrosselt und gleichzeitig der H₂S-Fluß von 0 auf 2 Vol-% erhöht. Auch die restlichen Gase wurden entsprechend angepaßt, so daß schließlich eine Gasmischung aus 96 Vol-% H₂, 2 Vol-% H₂S und 2 Vol-% TiCl₄ eingespeist wurde. Nach weiteren 60 Min. wurde die Zufuhr von H₂S und TiCl₄ abgestellt, die Energie abgeschaltet und die Proben wie im ersten Beispiel abgekühlt. Auf den Proben wurde eines insgesamt 6,5 µm dicke Schicht erhalten.

Anschließende Untersuchungen ergaben, daß sich im ersten Ausführungsbeispiel auf den Substratkörpern mit der Titannitridschicht eine 2 bis 3 µm dicke, bronzefarbene Schicht der Zusammensetzung TiSₓ gebildet hatte. Durch mikroskopische Untersuchungen konnte festgestellt werden, daß diese Schicht aus einem dichten, kristallinen Gefüge bestand, die gut auf der Zwischenschicht aus Titannitrid haftete. Die Mikrohärte der äußeren Titansulfid-Schicht betrug 1030 HV05. Röntgenspektroskopische Untersuchungen ergaben ferner, daß das Atomverhältnis des Titan zum Schwefel nahe bei 1 lag (gemessenes Verhältnis Ti: S = 1,02). Durch Röntgenbeugungsuntersuchungen wurde eine hexagonale Struktur von TiS mit a = 0,33 nm und c = 0,638 nm gefunden.

Weitere Beschichtungen mit anderen Versuchsparametern ergaben, daß das Atomverhältnis von S : Ti von etwa 0,8 bis 2,2 variiert werden kann. Die Zusammensetzung TiSₓ mit 0,8 ≤ x ≤ 2,2 richtet sich in erster Linie nach dem Mischungsverhältnis des titanhaltigen Gases (TiCl₄) und des schwefelhaltigen Gases (H₂S) sowie nach der Temperatur während der Beschichtung. Je nach Versuchseinstellungen konnten auch TiSₓ-Schichten erhalten werden, bei denen die abgeschiedene Schicht aus einem Phasengemisch aus TiS und TiS₂ bestand.

Im Unterschied zu den Proben des ersten Ausführungsbeispiels konnte bei dem letzten Ausführungsbeispiel mit einem Lichtmikroskop und auch mit einem Rasterelektronenmikroskop keine scharfe Grenzlinie zwischen der TiN-Schicht und der TiSₓ-Schicht beobachtet werden. Bei kalibrierten Kratzversuchen mit einem Diamantkörper konnten keine Abplatzungen zwischen diesen Schichten beobachtet werden. Die erfindungsgemäße Gradientenschicht (Ausführungsbeispiel (4)) vermittelt somit eine ausgezeichnete Haftung zwischen der TiN-Schicht und der TiSₓ-Schicht.

Wie bereits eingangs erwähnt, besteht bei der Bearbeitung von Werkstücken durch Drehen, Fräsen und Bohren ein großes Interesse, diese Bearbeitungsvorgänge ohne (umweltfeindliche) flüssige Kühlschmierstoffe durchzuführen. Mit den bisher zur Trockenbearbeitung vorgeschlagenen verschiedenen Schichtstoffen und Schichtsystemen, insbesondere aus Molybdändisulfid, konnten bereits beachtliche Fortschritte erzielt werden. Kristalline Molybdändisulfidschichten können durch CVD- oder Plasma-CVD-Verfahren hergestellt werden, allerdings bereitet die Handhabung des Prekursors für Molybdän, nämlich Molybdänchlorid beträchtliche Schwierigkeiten, da hierfür besondere Generatoren und Transportsysteme vorzusehen sind. Bei der Abscheidung von Titansulfid durch ein CVD- oder Plasma-CVD-Verfahren sind demgegenüber die technischen Voraussetzungen günstiger. Die Versorgung mit Titantetrachlorid gehört zur Grundausstattung der üblichen CVD- oder Plasma-CVD-Apparate für Hartstoffbeschichtungen, die häufig aus Carbiden, Nitriden und/oder Carbonitriden des Titan bestehen. Zur Herstellung von TiSₓ-Schichten ist somit bei den bestehenden Apparaturen lediglich noch eine Leitung für die Zufuhr von gasförmigem H₂S vorzusehen.

Die erfindungsgemäß beschichteten Schneideinsätze (Wendeschneidplatten) haben auch hervorragende Gebrauchseigenschaften, was anhand von durchgeführten Versuchen bei der Drehbearbeitung einer Welle aus rostfreiem Stahl festgestellt wurde.

Die Bearbeitungsparameter und Versuchsergebnisse der nach dem vorstehenden Ausführungsbeispiel hergestellten Schneidkörper sind im folgenden aufgeführt:
Werkstückstoff: Stahl X5CrNi1810 (Schlüssel-Nr. 1.4301)
Schneidkörper: CNMG120408
Schnittgeschwindigkeit: 160 m/min
Schnittiefe: 2,5 mm
Vorschub: 0.315 mm/U
Kein flüssiger Kühlschmierstoff

| Ausführung | Schichten | Standzeit |
|---|---|---|
| (1) einlagige Schicht | TiN (6 µm) | 14 min |
| | | |
| (2) zweilagige Schicht mit TiSₓ, x = 1.02 | TiN (4 µm) | |
| | TiS (2 µm) | 21 min |
| (3) dreilagige Schicht | TiN-TiCN-TiN (7,5 µm) | 18 min |
| | | |
| (4) mehrlagige Schicht mit einer Gradientenschicht TiSₓN_{y} | TiN (3 µm)- | |
| | TiSₓN_{y} (2 µm)- | |
| | TiSₓ (2,5 µm) | 23 min |
| | | |
| (5) mehrlagige Schicht mit einer Gradientenschicht TiSₓN_{y} und einer Mischphasenschicht | | |
| | TiN (4 µm) | |
| | TiSₓN_{y} (1,5 µm) | |
| | TiN_{0,2}S_{1,3} /2,5 µm) | 24 min |

Bei der Ausführung (2) gemäß obiger Tabelle wurden TiN und TiSₓ in einem Beschichtungszyklus durch ein Plasma-CVD-Verfahren aufgebracht. Die mehrlagige Beschichtung TiN-TiCN-TiN gemäß Ausführungsbeispiel (3) nach obiger Tabelle wurde in einem gesonderten Beschichtungslauf durch thermisches CVD bei etwa 1000°C hergestellt. Aus den Ausführungsbeispielen (4) und (5) mit einer erfindungsgemäßen Zwischenschicht wird deutlich, daß eine verbesserte Standzeit erreichbar ist.

Soll anstelle einer äußeren Festschmierstoffschicht eine abschließende, verschleißfeste Lage aus TiN oder Al₂O₃ aufgetragen werden, empfiehlt es sich, zusätzlich auf die nach Ausführungsbeispiel (4) beschriebene Schicht noch eine weitere Zwischenlage der Art TiSₓN_{y} aufzutragen, die ebenfalls einen Gradientenverlauf aufweist. Ist die äußere Schicht eine TiN-Schicht, so wird der Gradient derart gewählt, daß der N-Anteil in der vorletzten Schicht von innen nach außen zunimmt und der Schwefelanteil gleichermaßen auf 0 abnimmt.

Alle durchgeführten Schneidhaltigkeitsversuche wurden bis zum Bruch der Schneidecken oder einem unzulässige hohen Verschleiß der Wendeschneidplatten ausgedehnt. Ein Vergleich der in der vorstehenden Tabelle angegebenen Standzeiten zeigt, daß die Standzeit der erfindungsgemäßen Ausführung gegenüber den nicht erfindungsgemäßen Ausführungsbeispielen (1) bis (3) erheblich erhöht werden kann.

## Patentansprüche

1. Schneidwerkzeug zum Zerspanen, bestehend aus einem Hartmetall-, Cermet-, Keramik- oder Stahlgrundkörper und mindestens einer hierauf abgeschiedenen Schicht, wovon die einzige oder mindestens eine, mindestens 0,5 µm dicke Schicht, Anteile aus einem Metallsulfid- Festschmierstoff der Zusammensetzung MeSₓ mit Me = Ti, Zr oder Hf, vorzugsweise TiSₓ enthält,
**dadurch gekennzeichnet,**
**daß** die Schicht mit Anteilen aus einem Festschmierstoff die Zusammensetzung MeSₓN_{y} mit 0,1 ≤ y ≤ 0,9 und 0,1 ≤ x ≤ 2,2 aufweist.

2. Schneidwerkzeug nach Anspruch 1, **dadurch gekennzeichnet, daß** die Schicht mit Anteilen aus einem Festschmierstoff eine Zusammensetzung TiSₓN_{y} mit 0,2 ≤ y ≤ 0,8 und 0,2 ≤ x ≤ 1,6 aufweist.

3. Schneidwerkzeug nach Anspruch 1 oder 2, **dadurch gekennzeichnet, daß** die Dicke der Schicht mit Anteilen aus einem Festschmierstoff zwischen 1 µm und 5 um ist und/oder daß die Schicht mit Anteilen aus einem Festschmierstoff die äußere Schicht oder eine Zwischenschicht einer mehrlagigen Beschichtung ist.

4. Schneidwerkzeug nach einem der Ansprüche 1 bis 3, **dadurch gekennzeichnet, daß** auf dem Grundkörper eine mehrlagige Schicht abgeschieden worden ist, wovon mindestens eine Schicht im wesentlichen aus Carbiden, Nitriden, Carbonitriden, Oxicarbonitriden, Oxiden und/oder Boriden mindestens eines der Elemente der IVa- bis VIa-Gruppe des Periodensystems oder aus einer Keramik, vorzugsweise Al₂O₃ besteht.

5. Schneidwerkzeug nach Anspruch 4, **dadurch gekennzeichnet, daß** mindestens eine oder mehrere unmittelbar auf dem Grundkörper abgeschiedene Schicht(en) aus einem Metallcarbid, -nitrid, -carbonitrid, -oxicarbonitrid und/oder -oxid besteht, wobei das Metall eines oder mehrere Elemente der IVa- bis VIa-Gruppe des Periodensystems, vorzugsweise Ti, Zr und/oder Hf ist und daß die Schicht mit Anteilen aus einem Festschmierstoff die äußere Schicht oder eine Zwischenschicht ist, auf der als äußere 0,5 µm bis 5 µm dicke Schicht ein Hartstoff aus einem Carbid, Nitrid, Carbonitrid, Oxicarbonitrid, Oxid und/oder Borid, vorzugsweise TiN oder TiCN, oder eine 0,5 µm bis 5 µm dicke äußere Schicht aus Al₂O₃ abgeschieden worden ist.

6. Schneidwerkzeug nach Anspruch 5, **dadurch gekennzeichnet, daß** die MeN_{y}Sₓ-Zwischenschicht eine im wesentlichen homogene Zusammensetzung.

7. Schneidwerkzeug zum Zerspanen, bestehend aus einem Hartmetall-, Cermet-, Keramik- oder Stahlgrundkörper und mehreren hierauf abgeschiedenen Schichten, wovon mindestens eine aus einem Carbid, Nitrid, Carbonitrid, Oxicarbonitrid, Oxid und/oder Borid mindestens eines der Elemente der IVa- VIa-Gruppe des Periodensystems, oder aus einer Keramik, vorzugsweise Al₂O₃ besteht und eine Schicht Anteile aus einem Festschmierstoff enthält, **dadurch gekennzeichnet, daß** der Festschmierstoff die Zusammensetzung MeSₓN_{y} aufweist und als Zwischenschicht einen Gradientenverlauf mit kontinuierlich oder stufenweise wach senden oder fallenden Stickstoff- oder Schwefelanteilen mit Werten 0 ≤ x ≤ 2,2 und 0 ≤ y ≤ 1 besitzt.

8. Schneidwerkzeug nach Anspruch 7, **dadurch gekennzeichnet, daß** die auf dem Grundkörper, vorzugsweise aus Hartmetall, abgeschiedene mehrlagige Beschichtung, die Schichtfolge TiN-TiSₓN_{y}-TiSₓ-TiSₓN_{y}-TiN
TiN-TiSₓN_{y}-TiSₓ-TiSₓN_{y}-Al₂O₃
TiCN-TiSₓN_{y}-Al₂O₃ oder
TiCN-TiSₓN_{y}-TiN (jeweils von innen nach außen)
aufweist, wobei vorzugsweise die auf die grundkörpernähere TiN oder TiCN abgeschiedene TiSₓN_{y}-Schicht von innen nach außen einen wachsenden Sₓ-Anteil und einen fallenden Ny-Anteil vorzugsweise bis auf y = 0 fallenden Ny-Anteil aufweist und in der auf die TiSₓ-Schicht abgeschiedene TiSₓN_{y}-Schicht der Sₓ-Anteil fällt und der N_{y}-Anteil von innen nach außen wächst.

9. Verfahren zur Herstellung eines Schneidwerkzeuges nach einem der Ansprüche 1 bis 8, bei dem auf einem Grundkörper aus der Gasphase ein oder mehrere Schichten mittels CVD oder einem plasmaunterstützten CVD (PCVD) abgeschieden werden, **dadurch gekennzeichnet, daß** mittels CVD oder PCVD durch in die Gasphase eingeleitete Schwefelspender, nämlich H₂S, SF₆, SF₄, SO₂ und/oder COS und Stickstoff (N₂) sowie Ti-, Zr- und/oder Hf-Halogenide, Wasserstoff (H₂) sowie ggf. Argon die TiSₓN_{y}-Schicht abgeschieden wird.

10. Verfahren nach Anspruch , **dadurch gekennzeichnet, daß** während der TiSₓN_{y}-Abscheidung der Schwefelspender-Gehalt und der N₂-Gehalt entsprechend dem gewünschten Gradientenverlauf verändert werden.
